Europäisches Patentamt

European Patent Office

Office européen des brevets

(19)

(11) Numéro de publication : **0 071 506**
**B1**

(12) # FASCICULE DE BREVET EUROPÉEN

(45) Date de publication du fascicule du brevet :
**30.01.85**

(21) Numéro de dépôt : **82401305.6**

(22) Date de dépôt : **09.07.82**

(51) Int. Cl.⁴ : **H 04 N   5/95**, H 03 H 17/08,
H 03 L   7/00

(54) **Procédé et dispositif numérique de correction d'erreur de phase d'un signal échantillonné et son application à la correction de signaux de télévision.**

(30) Priorité : **24.07.81 FR 8114422**

(43) Date de publication de la demande :
**09.02.83 Bulletin 83/06**

(45) Mention de la délivrance du brevet :
**30.01.85 Bulletin 85/05**

(84) Etats contractants désignés :
**BE DE GB NL**

(56) Documents cités :
**FR-A- 2 381 428**
**PROCEEDINGS OF THE SYMPOSIUM ON COMPUTER PROCESSING IN COMMUNICATIONS, 8-10 avril 1969, pages 343-357, New York, USA W.E. LARIMORE: "Design and performance of a second order digital phase-locked loop"**

(73) Titulaire : **THOMSON-CSF**
**173, Boulevard Haussmann**
**F-75379 Paris Cedex 08 (FR)**

(72) Inventeur : **Rougeolle, Daniel**
**THOMSON-CSF SCPI 173, bld Haussmann**
**F-75379 Paris Cedex 08 (FR)**
Inventeur : **Porrot, Pascal**
**THOMSON-CSF SCPI 173, bld Haussmann**
**F-75379 Paris Cedex 08 (FR)**

(74) Mandataire : **Turlèque, Clotilde et al**
**THOMSON-CSF SCPI 173, Bld Haussmann**
**F-75379 Paris Cedex 08 (FR)**

EP 0 071 506 B1

Jouve, 18, rue St-Denis, 75001 Paris, France

## Description

La présente invention concerne un procédé numérique de correction de l'erreur de phase entachant un signal sinusoïdal de fréquence déterminée lors de sa conversion en un signal de type numérique, ladite conversion étant réalisée en échantillonnant le signal sinusoïdal à l'aide d'un signal d'horloge de fréquence multiple de quatre de la fréquence déterminée et en transformant les échantillons prélevés en un signal numérique représentatif de leur amplitude et de leur polarité.

L'invention concerne également un dispositif de mise en œuvre de ce procédé.

Pour réaliser l'opération de conversion analogique-numérique précitée il est connu de générer un signal d'horloge, de préférence de type impulsionnel pour définir avec précision les instants d'échantillonnage, dont la fréquence de récurrence est un multiple quadruple exact de la fréquence du signal sinusoïdal. Ce signal d'horloge est en général asservi sur le signal sinusoïdal et généré à l'aide d'un dispositif multiplicateur de fréquence. Il doit exister entre les deux signaux une relation de phase constante, d'amplitude et de signe préétablis pour obtenir une conversion analogique-numérique précise et fidèle.

Cette dernière condition n'est jamais parfaitement réalisée et il existe toujours en pratique une erreur de phase résiduelle malgré différents procédés permettant de minimiser cette erreur résiduelle.

Il est donc nécessaire, pour certaines applications pour lesquelles ce dernier paramètre est critique, de corriger le signal numérique issu de la conversion analogique-numérique avant toute utilisation pour tenir compte de l'erreur de phase résiduelle, erreur qui en outre peut fluctuer dans le temps en amplitude et en signe.

L'invention se propose de répondre à ce besoin.

La présente invention trouve son application principale dans le domaine de la télévision et plus spécifiquement dans le domaine de l'enregistrement et de la lecture de signaux de télévision à l'aide d'appareils du type magnétoscope ou analogues, les signaux étant des signaux composites codés selon un procédé du type N.T.S.C ou P.A.L.

Dans ces deux systèmes, comme il est connu, le signal de télévision composite comporte deux composantes : un signal vidéo constitué par un signal représentant la chrominance modulant en amplitude un signal sinusoïdal ou sous-porteuse auquel est ajouté un signal représentant la luminance. Le signal composite occupe une bande de fréquence comprise dans la gamme 5 à 6 MHz. En outre les signaux vidéo sont divisés en intervalles de temps représentant une ligne de balayage lors de leur restitution sur un écran de visualisation. Pour ce faire, il est transmis au début de chaque ligne un top de synchronisation suivi d'une salve de synchronisation ou « burst », selon la terminologie anglo-saxonne, consistant en une dizaine de périodes d'un signal sinusoïdal de même fréquence que celle de la sous-porteuse.

Le signal lu sur le support d'enregistrement d'un magnétoscope n'est pas directement mélangeable à des signaux produits par des circuits d'horloge. Il peut s'agir par exemple de générateurs de signaux d'horloge de studio dans les systèmes professionnels. Ce signal est en effet affecté d'une modulation de fréquence, due notamment aux circuits d'asservissements dont est généralement muni ce type d'appareil et à la nature élastique du matériau constituant le support d'information, bande magnétique par exemple.

Typiquement, l'écart de la fréquence de la sous-porteuse lue par rapport à sa valeur nominale peut atteindre $10^{-3}$. En valeur cumulée maximale un tel écart sur les fréquences se traduit par une variation de période pouvant atteindre plusieurs microsecondes. Or dans le type d'application envisagée, ces erreurs résiduelles ne doivent pas en général dépasser des valeurs de l'ordre de 2 à 3 ns.

Il est connu d'effectuer une correction, qui sera appelée dans ce qui suit correction principale, pour annuler l'erreur cumulée. Pour ce faire, il est d'usage d'utiliser une mémoire tampon du type mémoire vive à accès aléatoire, de capacité typiquement égale à trois lignes de balayage.

Il reste à effectuer une correction plus fine, qui sera appelée dans ce qui suit correction de vélocité, permettant de ramener l'erreur résiduelle à tout moment de l'intervalle de temps de balayage d'une ligne à une valeur inférieure à celle précitée.

L'invention se fixe également pour but, dans son application au domaine de la télévision, de répondre à ces besoins.

L'invention a donc pour objet un procédé numérique de correction de l'erreur de phase par rapport à une valeur de consigne prédéterminée introduite lors de la conversion analogique-numérique d'un signal sinusoïdal de fréquence déterminée F en une séquence de premiers signaux numériques représentatifs, ladite conversion étant réalisée par l'échantillonnage du signal analogique par un signal d'horloge périodique de fréquence égale à 4 nF, n' étant un nombre entier plus grand ou égal à 1 ; procédé principalement caractérisé en ce qu'il comprend les étapes suivantes :

mesure de l'angle de déphasage entre le signal analogique et le signal d'horloge et calcul de l'erreur de phase pour chaque période du signal analogique

création, par décalage dans le temps desdits premiers signaux numériques, d'une seconde séquence de signaux numériques, ce décalage étant égal à n périodes du signal d'horloge périodique, n étant ledit nombre entier

génération d'un signal numérique représentant la valeur des fonctions cosinus et sinus de l'erreur de phase

multiplication des premiers et seconds signaux numériques par les signaux numériques représentant respectivement les valeurs des fonctions cosinus et sinus de ladite erreur de phase

et addition des résultats de ces multiplications pour générer un troisième signal numérique, ce troisième signal étant égal au premier corrigé de ladite erreur de phase.

L'invention a encore pour objet un dispositif pour la mise en œuvre de ce procédé.

L'invention a enfin pour objet l'application de ce procédé et de ce dispositif à la correction d'erreur de phase d'un signal composite de télévision.

L'invention sera mieux comprise et d'autres avantages apparaîtront à l'aide de la description qui suit, en référence aux figures annexées :

la figure 1 représente schématiquement un système de conversion analogique-numérique dans lequel le dispositif de l'invention peut être mis en œuvre ;

la figure 2 est un diagramme illustrant le fonctionnement du système représenté sur la figure 1 ;

la figure 3 représente de façon plus détaillée le dispositif de l'invention ;

la figure 4 illustre l'application du dispositif de l'invention à la correction du signal représentant la chrominance dans un signal de télévision composite ;

la figure 5 illustre l'application du dispositif de l'invention à un système correcteur de base de temps d'un magnétoscope ;

la figure 6 représente de façon plus détaillée un circuit de calcul de phase mis en œuvre dans ledit système correcteur de base de temps ;

la figure 7 est un exemple de réalisation concrète du dispositif de l'invention selon une variante particulière ;

la figure 8 est un diagramme illustrant plus particulièrement le fonctionnement du circuit de calcul de la figure 6.

Dans ce qui suit les éléments communs à deux figures ou plus portent la même référence et ne seront décrits qu'une seule fois. Par convention, les liaisons monofilaires sont représentées par un trait unique, et les liaisons multifilaires (omnibus) par un trait double.

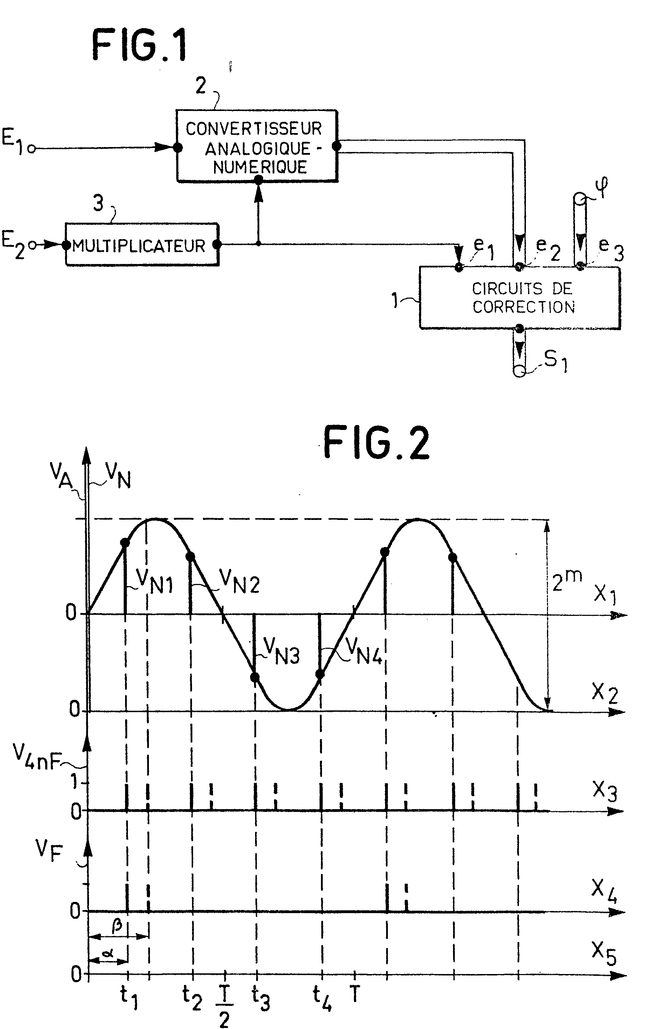

La figure 1 représente de façon schématique un système de conversion analogique-numérique. Un convertisseur 2 reçoit sur une entrée série $E_1$ le signal sinusoïdal à convertir, $V_A$, de fréquence F. L'entrée d'horloge du convertisseur 2 reçoit un signal d'échantillonnage de type impulsionnel $V_{4nF}$. La fréquence de répétition de ce signal est choisie pour être un multiple entier de quatre fois la fréquence du signal à convertir F, l'échantillonnage ayant lieu sur l'une des transitions des impulsions (par exemple sur le front de montée).

Le diagramme de la figure 2 illustre le processus de conversion. L'axe $OX_1$ représente le « zéro analogique », c'est-à-dire la valeur moyenne du signal sinusoïdal $V_A$. L'axe $OX_2$ représente le « zéro numérique » du signal converti.

Dans un exemple de réalisation concrète, le convertisseur analogique-numérique 2 est un convertisseur à sorties parallèles, par exemple fournissant un mot codé binaire de 9 bits, le bit de plus fort poids représentant le signe. L'amplitude crête à crête du signal sinusoïdal $V_A$ peut être décomposée en $2^m$ incréments, soit 512 dans le cadre de l'exemple choisi.

De façon usuelle, le signal d'échantillonnage est dérivé d'un signal $V_F$ présent sur l'entrée $E_2$ de même fréquence F que le signal analogique $V_A$, ce signal $V_F$ étant généralement asservi sur le signal analogique $V_A$ par des moyens non représentés sur la figure 1. Pour ce faire, on utilise un multiplicateur des fréquences 3 de type connu. Pour fixer les idées et pour simplifier la représentation des signaux, « n » a été choisi égal à un. Sur les axes $OX_3$ et $OX_4$ sont représentés en trait plein des impulsions constituant les signaux respectifs $V_{4nF}$ et $V_F$.

Le déphasage du signal $V_F$ par rapport au signal analogique $V_A$ est égal à $\alpha$, représenté sur l'axe des temps.

L'échantillonnage a lieu aux instants $t_1$, $t_2$, $t_3$ et $t_4$, (à l'intérieur d'une période T du signal analogique) et des mots successifs de 9 bits représentant l'amplitude des échantillons $V_{N1}$ à $V_{N4}$ sont disponibles sur les sorties parallèles du convertisseur analogique-numérique 2 après les instants d'échantillonnage.

Dans de nombreuses applications le déphasage entre le signal sinusoïdal à convertir et le signal d'échantillonnage doit être constant et égal à une valeur préétablie définie en amplitude et en signe. Dans ce qui suit, cette valeur sera appelée $\beta$ ou valeur de consigne.

Dans la réalité, comme représenté sur le diagramme de la figure 2, le déphasage réel $\alpha$ diffère de la valeur de consigne $\beta$, qui serait obtenue par les signaux d'échantillonnage représentée en traits interrompus.

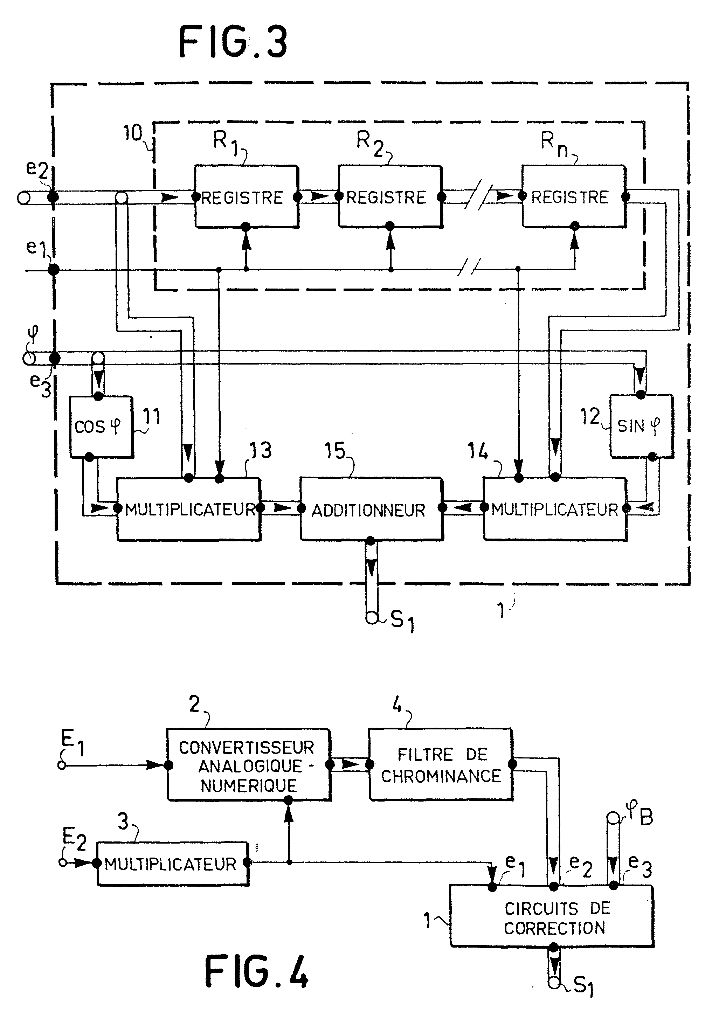

Il existe de nombreuses méthodes pour minimiser l'écart entre $\alpha$ et $\beta$ que l'on appellera dans ce qui suit erreur de phase résiduelle $\phi$, $\phi$ étant donné par la relation : $\phi = \beta - \alpha$. Pour de nombreuses applications, dont des exemples seront décrits dans ce qui suit en relation avec les figures 4 à 8, l'erreur résiduelle de phase $\phi$ reste cependant trop importante.

L'invention se fixe pour tâche un procédé permettant de corriger cette erreur résiduelle $\phi$. Un dispositif de mise en œuvre du procédé, représenté schématiquement par les circuits de correction 1 sur la figure 1 va maintenant être décrit. Ces circuits fournissent sur leurs sorties parallèles $S_1$ un signal numérique $V'_N$ représentant le signal numérique $V_N$ après correction. Pour ce faire, les circuits de

**0 071 506**

correction 1 reçoivent sur une première entrée $e_1$, le signal d'échantillonnage $V_{4nF}$, sur une deuxième entrée multiple $e_2$ le signal numérique fourni par le convertisseur analogique-numérique 2 et sur une troisième entrée $e_3$ des informations sous forme d'un mot binaire représentant l'erreur de phase résiduelle $\phi$.

La figure 3 représente de façon plus détaillée les circuits de correction 1. Ces circuits comprennent un module 10 comportant un nombre n de registres en cascade $R_1$ à $R_n$ à entrées et sorties parallèles. Chaque registre peut être constitué de bascules de type D, en nombre égal à celui des bits du mot binaire produit par le convertisseur analogique-numérique 2. L'entrée d'horloge dont est muni ce type de bascule reçoit le signal d'échantillonnage transmis à l'entrée $e_1$, des circuits de correction 1 et de fréquence 4 nF.

Il peut être utile de rappeler la configuration de ce type de bascule. Celle-ci, ainsi que la table de vérité et son diagramme de temps peuvent être trouvés, parmi d'autres publications, dans le livre français : « De la logique câblée aux microprocesseurs » par Bernard et autres, au tome 1, chapitre X.4 pages 136-138 (Editions Eyrolles ; Paris ; 1979).

Une telle bascule comporte une entrée de donnée, une entrée d'horloge, une entrée de positionnement (« preset »), une entrée de remise à zéro (« clear ») et deux sorties : vraie et inversée. Les entrées de prépositionnement et de remise à zéro sont asynchrones, et remettent la bascule à « 1 » ou « 0 » respectivement, indépendamment des signaux d'horloge. Le mode synchrone, sélectionné dans le cadre de la présente application est défini par l'entrée de donnée et l'entrée d'horloge. La bascule recopie l'entrée de donnée après l'apparition d'un front montant du signal d'horloge appliqué à l'entrée d'horloge, c'est-à-dire des impulsions du signal d'échantillonnage $V_{4nF}$.

Le mot binaire en sortie des bascules du registre $R_n$ est donc retardé de n impulsions d'horloge.

L'amplitude d'un échantillon à un instant quelconque t représentée par un mot binaire sur l'entrée multiple $e_2$ est égale à : $A \sin [2\pi Ft + \beta]$, A étant un coefficient proportionnel à l'amplitude du signal analogique $V_A$.

Le mot binaire sur les sorties du registre $R_n$ s'écrit :

$$A \sin [2\pi F((t-n)/4\,nF) + \beta], \text{ soit encore } -A\cos[2\pi Ft + \beta].$$

Les mots binaires en entrées et sorties du module 10 sont transmis respectivement à une première série d'entrées d'un premier multiplicateur numérique 13 et d'un second multiplicateur numérique 14. Ces multiplicateurs reçoivent sur une seconde série d'entrées des premiers et seconds mots binaires représentant le premier la fonction cosinus $\phi$ et le second la fonction sinus $\phi$. Ces fonctions peuvent être générées par tous moyens convenables : générateur de fonction, tableaux mémorisés, etc... Dans une variante de réalisation préférée, représentée sur la figure 3, deux mémoires semiconductrices 11 et 12 du type non-volatile programmable (P.R.O.M. selon la terminologie anglo-saxonne) sont utilisées pour produire les fonctions « cos $\phi$ » et « sin $\phi$ ». Ces mémoires 11 et 12 sont adressées par le mot binaire représentant l'erreur résiduelle de phase $\phi$. Chaque position de mémoire adressée est enregistrée, un mot binaire représentant la valeur de cosinus $\phi$ (mémoire 11) ou sinus $\phi$ recherchée (mémoire 12). Ces mots binaires en sorties des multiplicateurs 13 et 14 sont transmis à un additionneur binaire 15. Les multiplications s'effectuent au rythme de la fréquence du signal d'horloge $V_{4nF}$. Pour ce faire, ce signal est transmis à une entrée d'horloge dont est pourvu ce type de circuit.

Le mot binaire en sortie du multiplicateur 13 représente la valeur : $A \sin (2\pi Ft + \beta) \cos \phi$ et le mot binaire en sortie du multiplicateur 14, la valeur : $A \sin [2((t-n)\,4\,nF) + \beta] \sin \phi$ soit :

$A \cos (2\pi Ft + \beta) \sin \phi$. Il s'ensuit que le mot binaire en sortie $S_1$ de l'additionneur 15 s'écrit $A \sin (2\pi Ft + \alpha)$, signal qui est bien exempt de l'erreur de phase résiduelle $\phi$ amenée par la conversion analogique-numérique.

Les circuits de correction constituant le dispositif objet principal de l'invention, tels que représentés sur les figures 1 et 3, peuvent être réalisés à l'aide d'éléments disponibles du commerce ou réalisés par câblage d'éléments discrets. Sur cette figure n'ont pas été représentés les circuits d'alimentation en tension ni les circuits véhiculant des signaux de service et d'horloges internes qui dépendent essentiellement d'un choix technologique et sont à la portée de l'homme de métier.

A titre d'illustration, le convertisseur analogique-numérique 2 peut être du type D.T.C. 1019 et les multiplicateurs 13 et 14 du type MPY8HJ, commercialisés par la Société T.R.W. Les registres $R_1$ à $R_n$ peuvent être réalisés à partir de circuits intégrés du type 74LS374 et l'additionneur 15 à partir de circuits intégrés du type 74LS283, commercialisés par la Société Texas Instruments.

Les mémoires 11 et 12 sont des mémoires P.R.O.M., par exemple du type HM 76161-5 de capacité $8 \times 2$ Kbits commercialisées par la Société Harris.

L'information donnant l'erreur de phase résiduelle $\phi$ peut être obtenue par tous moyens appropriés de l'art connu et est à la portée de l'homme de métier. Le procédé de mesure de l'erreur de phase résiduelle $\phi$ sort du cadre de la présente invention. Cependant, il peut être utile de décrire brièvement un procédé permettant cette mesure avec rapidité et précision particulièrement adapté à la présente invention.

Selon ce procédé, on échantillonne le signal analogique à convertir de manière analogique à ce qui a été décrit en relation avec le diagramme de la figure 2, à l'aide d'un signal de fréquence quadruple de la fréquence du signal analogique $V_A$. Dans le cadre de l'exemple choisi, le convertisseur analogique-

4

numérique fournit un mot binaire de 9 bits, le bit de plus fort poids représentant le signe de l'échantillon. Il y a donc 512 niveaux numériques possibles.

On utilise, à l'intérieur d'une période, l'échantillon référence $V_{N1}$ qui représente sin $\alpha$ et l'échantillon $V_{N2}$ qui représente cos $\alpha$ ou connaissant $\beta$, sin $\phi$ et cos $\phi$. Pour ce faire, lorsque la valeur numérique de l'échantillon est supérieure à 256 (arche positive de la sinusoïde), on utilise directement cette valeur numérique pour le calcul des deux fonctions. Dans le cas contraire, c'est-à-dire entre 0 et 256 (arche négative), on complémente à deux la valeur numérique fournie par le convertisseur. La discrimination s'effectue par l'examen du bit $2^8$ représentant le signe. En réalité les valeurs échantillonnées représentent respectivement A sin $\phi$ et A cos $\phi$, A étant l'amplitude maximale du signal analogique. Pour s'affranchir du coefficient A, on calcule ensuite tg $\phi$ ou cotg $\phi$, selon que | A sin $\phi$ | soit plus petit ou plus grand que | A cos $\phi$ |. Pour ce faire, on effectue la comparaison entre ces deux dernières valeurs.

Selon ce procédé, on calcule les valeurs absolues de tg $\phi$ et cotg $\phi$, ce de la manière suivante :

$$| \text{tg } \phi | = A | \sin \phi | \times 1(1/A | \cos \phi |)$$

et

$$| \text{cotg } \phi | = A | \cos \phi | \times 1 A | \sin \phi |)$$

L'inversion des fonctions A | cos $\phi$ | et | A sin $\phi$ | peut être réalisée à l'aide de mémoires de type P.R.O.M., analogues à celles mises en œuvre dans le dispositif décrit en relation avec la figure 3, et adressées par les mots binaires représentant : | A cos $\phi$ | et | A sin $\phi$ |.

Comme il vient d'être rappelé, selon le résultat de la comparaison entre les valeurs | A sin $\phi$ | et | A cos $\phi$ |, dans une dernière étape du procédé, l'angle est calculé respectivement à partir de tg $\phi$ ou cotg $\phi$. On peut également, pour effectuer ce calcul, utiliser une mémoire de type PROM adressée par le mot binaire représentant tg $\phi$ ou cotg $\phi$ et fournissant un mot binaire sur sa sortie représentant l'erreur de phase résiduelle recherchée $\phi$.

Par ce procédé, la mesure de $\phi$ est indépendante de l'amplitude du signal sinusoïdal et la précision obtenue dépend uniquement du nombre de bits fournis par le convertisseur analogique-numérique. Dans l'exemple choisi, la précision avec 9 bits est supérieure à 1°. Enfin les informations nécessaires au calcul de $\Phi$, constituées essentiellement par les échantillons $V_{N1}$ et $V_{N2}$, sont directement disponibles dans le cadre de la présente invention.

Le procédé de l'invention, tel qu'il vient d'être décrit est susceptible de nombreuses applications et notamment dans le domaine de la télévision, pour la correction d'erreur de phase lors de l'échantillonnage de signaux mis en œuvre dans les systèmes simultanés de télévision en couleur de type N.T.S.C., P.A.L. ou analogues. Comme il a été rappelé le signal de télévision composite P.A.L. ou N.T.S.C. est constitué d'un signal vidéofréquence comportant un signal représentant la chrominance modulant en amplitude un signal sinusoïdal de sous-porteuse à fréquence fixe $F_{sc}$ auquel est ajouté un signal représentant la luminance.

Dans le cas du système N.T.S.C., la fréquence du signal de sous-porteuse est égal à : $F_{sc} = 455/2 \cdot F\rho$, $F\rho$ étant la fréquence de répétition d'une ligne de balayage lors de la restitution sur un écran de visualisation des informations vidéofréquences.

Le signal de chrominance est décomposable également en deux composantes I et Q modulant en amplitude deux sous-porteuses, de fréquence $F_{SC}$ et en quadrature soit :

$$I \sin (2 \pi F_{sc} t) + Q \sin (2 \pi F_{sc} t + (\pi/2))$$

ou encore :

$$I^2 + Q^2 \sin (2 \pi F_{sc} t + \gamma), \text{ avec tg } \gamma = Q/I.$$

C'est un signal sinusoïdal dont l'amplitude est caractéristique de la saturation et la phase de la teinte. Il a été également rappelé qu'au début de chaque ligne de balayage est transmis, entre autre, une salve de signaux sinusoïdaux à la fréquence de la sous-porteuse $F_{sc}$.

Dans le cas du système P.A.L., la fréquence du signal de sous-porteuse est égal à : $F_{sc} = (1\ 135/4) F\rho + 25$ Hz. La chrominance est constituée de deux composantes : U et V.

La première, U, module en amplitude un signal de sous-porteuse à la fréquence $F_{sc}$ et la seconde, V, module en phase, à $+ \pi/2$ radians d'une ligne de balayage à la suivante, un second signal de sous-porteuse de même fréquence. Le signal résultant est donné par la relation :

$$V \sin (2 \pi F_{sc} t) + V \sin (2 \pi F_{sc} t \pm (\pi/2)).$$

Ceci constitue également un signal sinusoïdal dont l'amplitude est caractéristique de la saturation et la phase de la teinte.

Il est d'usage, notamment pour l'enregistrement de signaux vidéo, de numériser à la lecture ces signaux pour effectuer des corrections par des procédés numériques. Dans ce cadre d'application, on retrouve les difficultés précédemment énoncées à savoir un échantillonnage du signal composite avec une erreur de phase résiduelle $\phi$. Les signaux composites étant du type qui vient d'être rappelé, il est possible de les convertir de façon analogue à ce qui a été décrit en relation avec les figures 1 et 2. Les procédés connus permettant de minimiser l'erreur de phase résiduelle à une valeur typique de 11° (0,2 radian environ), ce qui constitue un niveau d'erreur intolérable pour l'application considérée, notamment en ce qui concerne la chrominance. Le procédé de l'invention peut donc être mis en œuvre avec profit et, sinon annuler entièrement l'erreur de phase, la ramener à une valeur typiquement inférieure à 1° ($17 \cdot 10^{-3}$ radians).

La figure 4 illustre schématiquement l'application du procédé de l'invention à la correction de l'erreur de phase apparaissant lors de l'échantillonnage du signal de chrominance. On retrouve, sous les mêmes références, les éléments décrits en relation avec le système de la figure 1 et qui ne seront pas décrits à nouveau. Le signal à convertir est le signal composite transmis à la borne d'entrée $E_1$. Un signal impulsionnel de fréquence égale à la fréquence de sous-porteuse est transmis à la borne d'entrée $E_2$ et converti par le multiplicateur 3 en un signal d'échantillonnage dont la fréquence sera choisie à titre d'illustration du procédé égale à quatre fois la fréquence du signal d'entrée (soit n = 1).

Le système diffère de celui de la figure 1 par le fait que le signal représentant la composante de chrominance est tout d'abord extrait du signal numérique avant d'être transmis aux circuits de correction 1 identiques à ceux des figures 1 et 3. Pour ce faire, on utilise un filtre numérique 4 de tout type connu, par exemple un filtre transversal. L'erreur résiduelle de phase $\phi_B$ transmise à l'entrée $e_3$ des circuits de correction est mesurée sur les signaux de salves transmis en début de ligne de balayage. Toute méthode de mesure de phase peut être mise en œuvre et notamment celle qui a été décrite précédemment. Sur la sortie $S_1$, est donc disponible un signal numérique corrigé représentant la chrominance.

Le dispositif qui vient d'être décrit peut être mis en œuvre notamment dans un magnétoscope et en particulier un magnétoscope professionnel utilisé dans un studio d'enregistrement.

Dans le préambule de la présente description, il a été rappelé que les signaux lus sur une bande d'enregistrement n'étaient pas directement mélangeables avec d'autres sources stables.

Dans ce cadre d'applications, outre la correction principale qui permet d'annuler l'erreur cumulée, réalisée par des méthodes classiques, il est nécessaire d'effectuer une seconde correction, dite de vélocité.

Pour celle-ci, le procédé de l'invention peut également être mis en œuvre avec profit et le système décrit en relation avec la figure 4 utilisée. Cependant une mesure unique de l'erreur de phase par ligne de balayage n'est pas suffisante pour obtenir le résultat recherché. Cette erreur fluctue tout au long de l'intervalle de temps d'une ligne de balayage. Il n'est cependant pas envisageable de façon pratique de mesurer cette variation en continu.

Selon un aspect supplémentaire de l'invention, la mesure de l'erreur de phase résiduelle va être calculée en un certain nombre de points d'une ligne de balayage par interpolation sur les variations des valeurs d'erreurs résiduelles de phase réellement mesurées d'une ligne à la suivante.

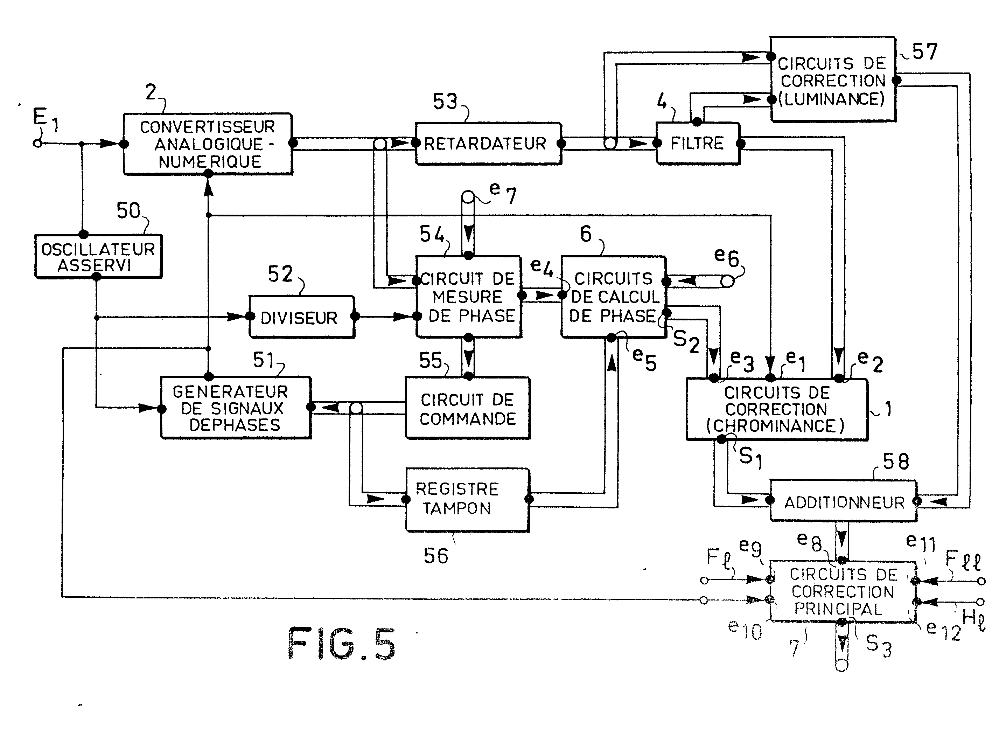

La figure 5 représente schématiquement les organes principaux d'une base de temps d'un magnétoscope, limités aux seuls organes nécessaires à la compréhension de la présente application. Comme précédemment, le signal composite est transmis à la borne d'entrée $E_1$ et converti en un signal numérique par le convertisseur analogique-numérique 2. Le signal d'échantillonnage est généré à partir du signal composite par exemple à l'aide d'un oscillateur asservi en tension du type dit « V.C.O. » selon la terminologie anglo-saxonne. Le signal en sortie de cet oscillateur est un signal impulsionnel de fréquence 4 $F_{sc}$, $F_{sc}$ étant la fréquence de sous-porteuse.

La base de temps comporte également un dispositif permettant de minimiser l'erreur de phase résiduelle $\phi$. Ce dispositif sort du cadre de l'invention. Il est cependant utile d'en décrire succinctement le fonctionnement.

Un circuit de mesure de phase 54, par exemple du type mettant en œuvre le procédé précédemment décrit, mesure la phase résiduelle sur la salve de signaux à fréquence $F_{sc}$. Il reçoit sur une entrée d'horloge un signal à la même fréquence. Pour ce faire, un diviseur par quatre 52, un compteur binaire de capacité quatre par exemple, est interposé entre l'oscillateur asservi 50 et l'entrée d'horloge du circuit de mesure de phase 54. Celui-ci reçoit en outre différents signaux de service permettant notamment de définir une fenêtre de temps pour la mesure de phase sur une entrée multiple $e_7$.

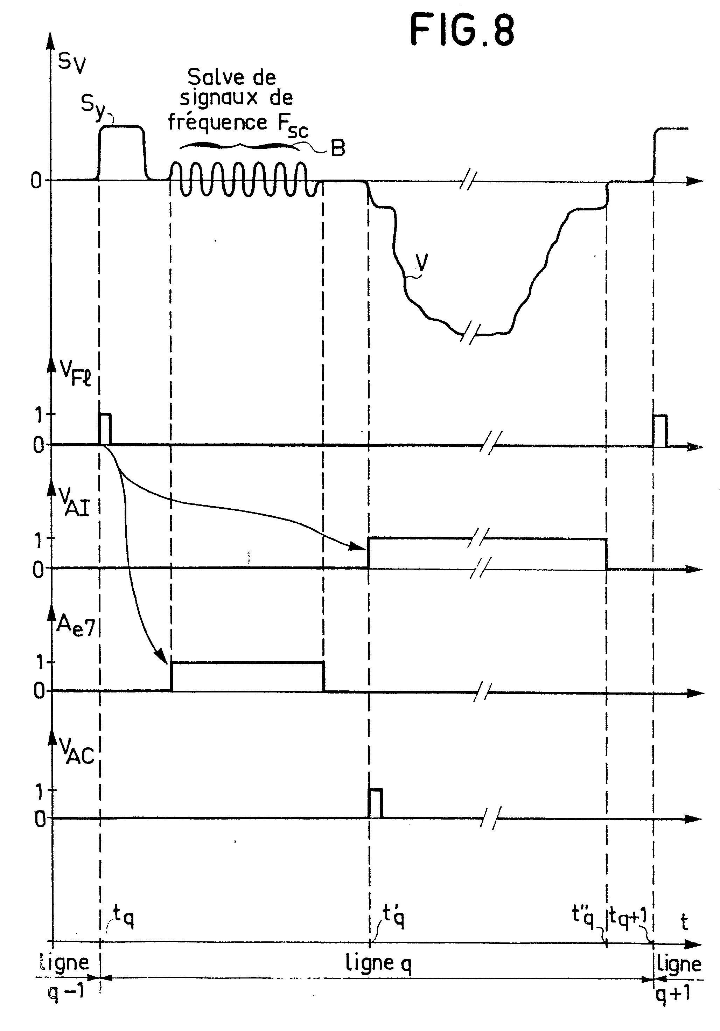

Si on se reporte au diagramme de la figure 8, sur la partie supérieure est représentée un signal composite $S_V$ de type N.T.S.C. classique. Il comporte en début de ligne de balayage, la ligne de rang q sur le diagramme de la figure 8 un top de synchronisation $S_y$ suivi de la salve de sinusoïdes B de fréquence $F_{sc}$. Le zéro sur l'axe vertical représente le niveau dit de suppression et également la valeur moyenne des sinusoïdes de la salve B. Il est donc aisé de dériver un signal impulsionnel $V_{F1}$ à la fréquence de répétition de ligne pour définir le début d'une ligne, à l'instant $t_q$ sur l'axe des temps t. De cette impulsion peut être dérivée à son tour une fenêtre d'autorisation $A_{e7}$ de mesure de la phase de la salve B, connaissant les normes légales régissant le standard de télévision utilisé.

Le circuit de mesure de phase 54 reçoit également sur l'omnibus d'entrée $e_7$ un mot binaire représentant la valeur de consigne de la phase à respecter $\beta$. De la valeur mesurée $\alpha$ et de cette dernière valeur $\beta$, le circuit de mesure élabore la valeur de l'erreur résiduelle sous forme d'un mot binaire transmis à un circuit de commande 55, qui peut, par exemple, comprendre une mémoire de type P.R.O.M. adressée par le mot binaire représentant $\phi$, et élaborant un mot de commande transmis à un générateur de signaux déphasés 51. Celui-ci a pour rôle d'élaborer à partir du signal de sortie de l'oscillateur 50 une suite de signaux impulsionnels de même fréquence de répétition (4 $f_{sc}$) que celle du signal de sortie de l'oscillateur, les différents signaux de la suite étant déphasés les uns par rapport aux autres d'un même incrément. Ce générateur 51 comporte un circuit multiplexeur commandé par le mot binaire élaboré par le circuit de commande 55 de manière à sélectionner l'un desdits signaux de la suite qui est seul transmis à l'entrée d'échantillonnage du convertisseur analogique-numérique 2, ce de manière à minimiser l'erreur résiduelle de phase φ par un choix approprié du signal d'échantillonnage occasionnant l'erreur minimale.

On suppose que la mesure est effectuée au début de la ligne de balayage de rang (q − 1). On appellera dans ce qui suit le déphasage après correction par ce procédé $\alpha_1$ et plus généralement $a_1^{q-1}$ pour tenir compte de l'instant de mesure. Cette valeur $\alpha_1^{q-1}$ est enregistrée dans un registre tampon 56 pendant la durée d'un intervalle de temps d'une ligne de balayage et restituée sur la sortie de ce registre à la ligne de balayage suivante. Pour ce faire, de signaux d'autorisation d'écriture et de lecture non représentés assurent ce séquencement. Ils peuvent être également dérivés simplement du signal $V_{F1}$ déjà décrit.

Le signal numérique en sortie du convertisseur analogique-numérique est également retardé, ce par un circuit retardateur 53. Ce circuit peut être constitué de registres à décalages à entrées et sorties parallèle d'un intervalle de temps T égal à une ligne de balayage. La sortie de ce circuit est reliée à l'entrée du filtre 4 décrit en relation avec la figure 4 et dont le rôle est d'extraire le signal de chrominance transmis à l'entrée $e_2$ des circuits de correction 1. Ces circuits reçoivent comme précédemment sur l'entrée $e_1$ le signal d'échantillonnage.

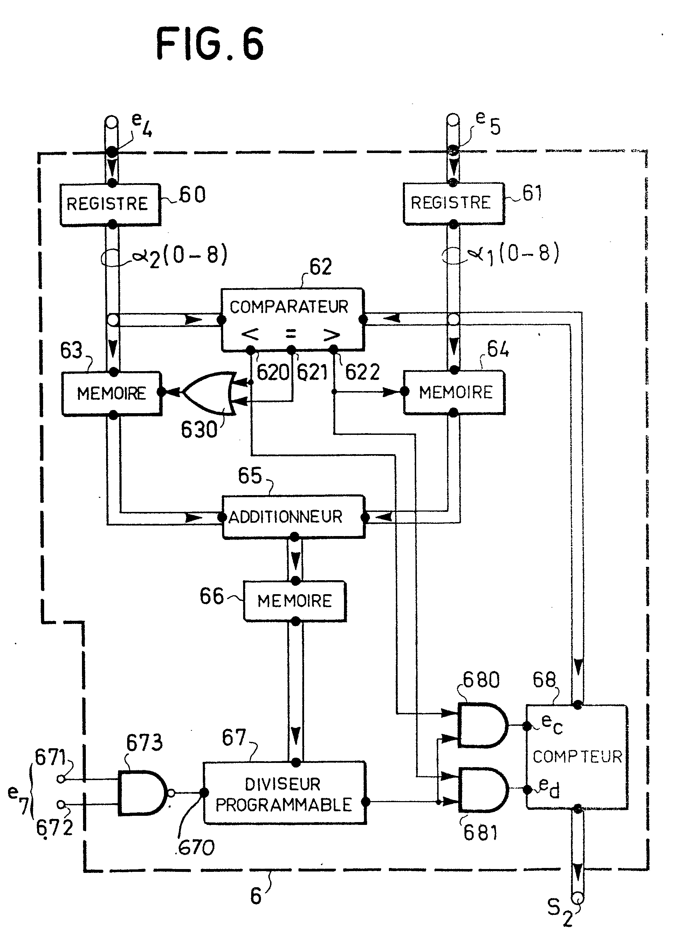

Il est nécessaire dans l'application décrite, de connaître à tout instant de l'intervalle de temps d'une ligne de balayage des informations sur l'erreur de phase apportée par la conversion au signal de chrominance. Pour ce faire, un circuit de calcul de phase 6 reçoit au début de chaque ligne de balayage d'une part la valeur du déphasage résiduel : $\alpha_1^{q-1}$ disponible à la sortie du registre tampon 56 et élaborée à la ligne (q − 1) et du circuit de mesure de phase 54 la valeur mesurée en début de ligne de rang q et qui sera appelée $\alpha_2^q$. Cette valeur représente également avec une bonne approximation la valeur de déphasage en fin de ligne de balayage de rang (q − 1). Les circuits de calcul de phase 6 ont pour rôle de calculer par interpolation en un nombre de points important de l'intervalle de temps d'une ligne de balayage l'erreur de phase résiduelle φ instantanée à partir du calcul de $| \alpha_2^q - \alpha_1^{q-1} |$, deux données présentes sur les entrées respectives $e_4$ et $e_5$. Les circuits de calcul de phase seront décrits en détail ultérieurement en relation avec la figure 6. L'erreur de phase résiduelle φ, disponible sur la sortie $S_2$ est transmise à l'entrée $e_3$ des circuits de correction 1 qui élabore à partir des données d'entrée un signal de chrominance corrigé disponible sur la sortie $S_1$.

Pour compléter la description du système de la figure 5, il est à indiquer que les circuits de correction 57 extraient le signal de luminance du signal numérique en sortie du retardateur 53 et corrigent le signal par un procédé qui sort du cadre de la présente invention. Cette étape de correction peut cependant être omise dans certaines utilisations car les erreurs de phase sur le signal de luminance sont moins critiques que celles apportées au signal de chrominance lors de l'échantillonnage. Le signal composite corrigé est ensuite reconstitué par addition dans l'additionneur numérique 58 et transmis à des circuits de correction principale 7 classiques. Il est cependant utile d'en rappeler brièvement le fonctionnement.

Ces circuits 7 comprennent essentiellement une mémoire à accès aléatoire de capacité typique égale à trois lignes de balayage. Le signal corrigé en vélocité par le procédé qui vient d'être décrit est transmis à l'entrée données $e_8$ de la mémoire et écrit à des adresses générées par un premier compteur d'adresse qui reçoit d'une part, sur l'entrée $e_9$ un signal de synchronisation ligne $F_1$ lu à partir du signal vidéo non corrigé et d'autre part, sur l'entrée $e_{10}$ un signal d'horloge sous la forme du signal d'échantillonnage. Le premier signal $F_1$ peut être dérivé du signal $V_{F1}$ représenté sur la figure 8.

Les signaux ainsi enregistrés dans la mémoire des circuits de correction principale 7 sont ensuite lus à l'aide de signaux stables générés localement par des circuits extérieurs au magnétoscope non représentés sur la figure 5, ces signaux étant d'une part, un signal de synchronisation ligne $F_{11}$ sur l'entrée $e_{11}$ et un signal d'horloge $H_1$ sur l'entrée $e_{12}$, à la fréquence 4 $F_{sc}$. La mémoire des circuits 7 joue le rôle d'une mémoire tampon et, par ce procédé, l'erreur cumulée est supprimée. Le signal disponible en sortie $S_3$ des circuits de correction principale est donc corrigé pour les deux types d'erreurs ; vélocité et erreur cumulée.

Les circuits de calcul de phase 6 sont représentés de façon plus détaillée sur la figure 6.

Les valeurs $\alpha_1^q$ et $\alpha_2^{q-1}$ sont enregistrées respectivement dans les registres 61 et 60, qui sont des registres de capacité 9 bits. Pour simplifier la description du dispositif, les liaisons d'alimentation en tension des différents circuits et les signaux de service et d'horloges internes n'ont pas été représentés. Ils sont liés au choix technologique effectué lors de la réalisation concrète de ces circuits. Les registres ont une capacité de 9 bits dans le cadre de l'exemple retenu.

Le calcul point par point de l'erreur de phase résiduelle s'effectue de la façon qui va être décrite dans ce qui suit. La valeur $\alpha_1^{q-1}$ ou déphasage résiduel initialise à chaque début de ligne de balayage un compteur 68 susceptible d'être incrémenté ou décrémenté sous la commande de signaux de commande à deux états logiques transmis, respectivement, à une entrée d'incrémentation $e_c$ et à une entrée de décrémentation $e_d$. Les incrémentations ou les décrémentations s'effectuent à chaque impulsion d'un signal d'horloge généré par un diviseur programmable 67. L'état de chargement de ce diviseur dépend de la différence $| \alpha_2^{q-1} - \alpha_1^q |$. Le rôle de ce diviseur est de répartir le mieux possible dans l'intervalle de temps T d'une ligne de balayage les incrémentations ou décrémentations successives du compteur 68 qui doit fournir en sortie $S_2$, pour chaque impulsion d'horloge, un mot binaire dont la valeur est intermédiaire

7

entre $\alpha_2{}^{q-1}$ et $\alpha_2{}^q$. La capacité maximale du diviseur programmable 67 détermine la précision de l'interpolation. Une valeur typique est 512, maximum que permet un mot de 9 bits. Il y a donc possibilité de produire un nombre d'impulsions d'horloges compris entre 0 et 512 selon le mot binaire de chargement. Ces impulsions d'horloges, réparties de façon optimale dans l'intervalle de temps T d'une ligne de balayage, sont transmises à une des bornes d'entrée de deux portes logiques ET, 680 et 681 dont les sorties sont reliées respectivement aux entrées d'incrémentation $e_c$ et de décrémentation $e_d$ du compteur 68.

Le diviseur programmable reçoit sur une entrée d'horloge 670, des signaux d'horloge dont la fréquence est déterminée par la capacité du diviseur, c'est-à-dire le nombre maximum de points de calculs de l'erreur de phase (512 dans l'exemple choisi) et par l'inverse de la durée du signal vidéo (qui dépend du système choisi : P.A.L., N.T.S.C. etc...). Le signal d'horloge peut être produit par tout oscillateur classique, non représenté sur la figure. Il est transmis aux circuits 6 par l'une des lignes 671 constituant l'entrée multiple $e_7$.

La transmission effective de ce signal d'horloge n'est autorisée qu'à l'intérieur d'une fenêtre de temps correspondant à la durée du signal vidéo proprement dit. Pour ce faire, une porte logique NON-ET 673 est utilisée. Cette porte reçoit sur l'une de ces entrées le signal d'horloge et sur l'autre entrée un signal d'autorisation de calcul.

Si on se reporte de nouveau à la figure 8, les calculs successifs d'erreurs de phase résiduelles $\phi$ doivent prendre place pendant l'intervalle de temps $t'q$ à $t''q$, durée effective du signal vidéo V, et notamment du signal de chrominance qui doit être corrigé. Pour ce faire, un signal logique $V_{AI}$ d'autorisation d'interpolation est créé. Connaissant les normes du standard utilisé, il peut être dérivé simplement du signal $V_{F1}$ déjà décrit. Le signal d'autorisation $V_{AI}$ est transmis par la liaison 672.

Il doit être bien entendu que les corrections qui vont être effectuées pendant l'intervalle de temps $t'_q - t''_q$ concernent non le signal de chrominance de la ligne de balayage de rang q mais le signal de chrominance de la ligne de rang $(q-1)$ qui est transmis pendant cet intervalle de temps par le circuit retardateur 53 (fig. 5) aux circuits de correction 1. La correction sur le signal de chrominance de la ligne de balayage de rang q aura lieu à la ligne de balayage de rang $q+1$.

Avant de transmettre une information de chargement au diviseur programmable, il est nécessaire de connaître le signe de la différence $\alpha_2{}^{q-1} - \alpha_1{}^q$. Pour ce faire, les deux signaux $\alpha_2{}^{q-1}$ et $\alpha_1{}^q$ transmis à un comparateur binaire 62. Les sorties 620, 621 et 622 indiquent par la présence d'un « 1 » logique, respectivement : $|\alpha_2{}^{q-1}| < |\alpha_1{}^q|$, $|\alpha_2{}^{q-1}| = |\alpha_1{}^q|$, et $|\alpha_2{}^{q-1}| > |\alpha_1{}^q|$. Les signaux sur les sorties 620 et 621 sont transmis, respectivement aux secondes entrées des portes logique ET 680 et 681 commandant l'incrémentation et la décrémentation du compteur 68. Celui-ci a la même capacité que le diviseur programmable 67.

Lorsque $|\alpha_2{}^{q-1}|$ est inférieur ou égal à $|\alpha_1{}^q|$ le complément à deux de la valeur $|\alpha_2{}^{q-1}|$ est utilisé pour le calcul. Pour ce faire, une mémoire 63 de type P.R.O.M. peut être utilisée dans laquelle sont enregistrés les valeurs vraies et les compléments à deux de la valeur $|\alpha_2{}^{q-1}|$. La mémoire est adressée par le mot binaire en sortie du registre 60 et, selon la valeur d'un bit supplémentaire d'adresse transmis par une porte OU 630 recevant sur deux entrées les bits transmis par les sorties 620 et 621, la valeur vraie $|\alpha_2{}^{q-1}|$, ou son complément à deux, est disponible sur la sortie de la mémoire 63. De manière analogue, sous la commande du bit transmis par la sortie 622 ($|\alpha_2{}^{q-1}| > |\alpha_1{}^q|$) une deuxième mémoire 64 adressée par $\alpha_1{}^q$ fournit sur sa sortie la valeur vraie de $|\alpha_1{}^q|$ ou son complément à deux. Un additionneur binaire 65 génère la valeur $|\alpha_2{}^{q-1} - \alpha_1{}^q|$ qui représente l'amplitude de variation du déphasage entre le début de la ligne de balayage de rang $(q-1)$ et la fin de cette même ligne, ce par le biais de la mesure de déphasage $\alpha_1{}^q$ de la salve B en début de ligne de rang q.

Une troisième mémoire 66 convertit ce mot binaire en un mot de chargement nécessaire pour la programmation correcte du diviseur 67.

Lorsque $|\alpha_2{}^{q-1}| = |\alpha_1{}^q|$, aucune interpolation n'est effectuée, les portes 680 et 681 restent d'ailleurs bloquées (signal « 0 » logique sur les sorties 620 et 622. La sortie $S_2$ conserve une valeur constante égale à la valeur d'initialisation du compteur 68, c'est-à-dire également à la valeur précédemment atteinte $\alpha_2{}^{q-1}$.

Le compteur 68 génère à tout instant la valeur de l'erreur résiduelle $\phi_B$ appartenant à l'intervalle numérique $|0 ; 512|$ c'est-à-dire représentant un déphasage exprimé en radians appartenant à l'intervalle $|\pi, \pi|$. Les éléments nécessaires à la réalisation concrète des circuits de calcul de la figure 6 peuvent être choisis parmi des éléments disponibles du commerce ou être réalisés par câblage d'éléments discrets. A titre de simple illustration, les registres 60 et 61 peuvent être réalisés à l'aide de circuits intégrés du type 74LS374, le comparateur 62 peut être du type 74LS85, l'additionneur 65 du type 74LS283, le diviseur programmable 67 du type 74LS97 et le compteur 68 du type 74LS193. Ces circuits sont commercialisés par la Société Texas Instruments. Les portes logiques 630, 680, 681 et 673 peuvent être réalisées à partir d'éléments de circuits intégrés compatibles avec les autres circuits intégrés qui viennent d'être mentionnés. Les mémoires 63, 64 et 66 peuvent être du type précédemment mentionné.

Dans l'exemple particulier d'application qui vient d'être décrit en relation avec la figure 6, il est difficile d'obtenir une vitesse de correction compatible avec le temps disponible pour effectuer cette correction en mettant en œuvre des circuits de correction ayant la configuration illustrée par la figure 4.

En effet, le nombre de corrections successives pendant l'intervalle de temps T d'une ligne de balayage peut atteindre une valeur importante jusqu'à 512 dans l'exemple considéré. Il est notamment difficile de réaliser des multiplicateurs binaires très rapides, sauf à utiliser des technologies onéreuses.

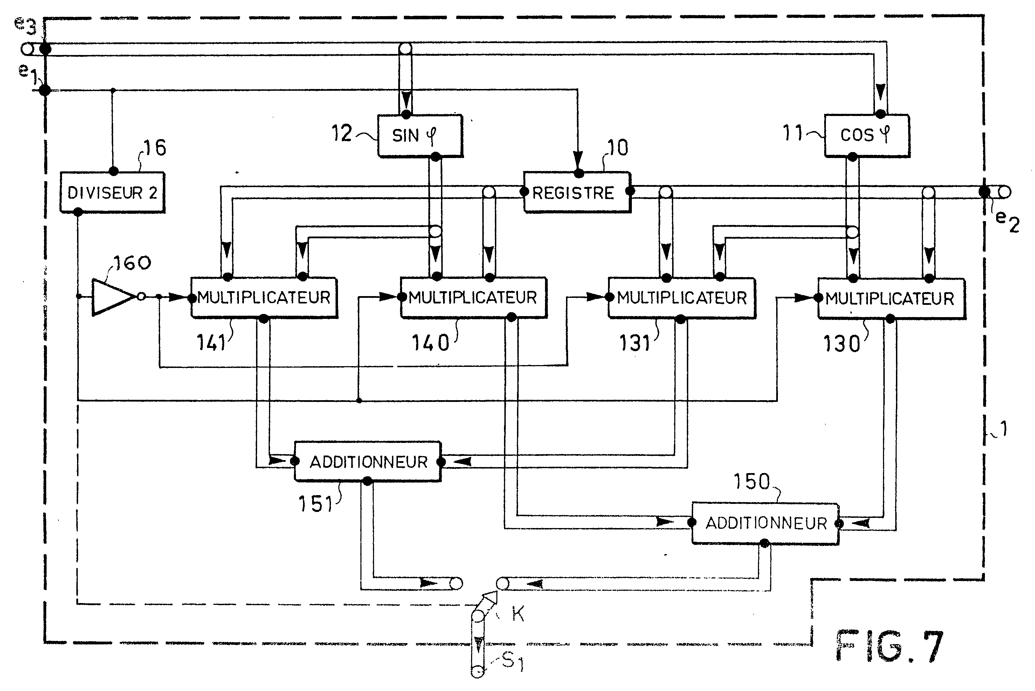

La figure 7 représente une variante de réalisation concrète des circuits de correction 1 particulièrement adaptée à l'application qui vient d'être décrite.

L'opération de multiplication est réalisée en remplaçant les multiplicateurs 13 et 14 de la figure 3 par quatre multiplicateurs 130 et 131, 140 et 141 ; les multiplicateurs 130 et 131, d'une part, et les multiplicateurs 140 et 141, d'autre part, fonctionnant à tour de rôle.

Pour ce faire un signal d'horloge à fréquence 2 $F_{sc}$ est créé à partir du signal d'horloge (4 $F_{sc}$) transmis à l'entrée $e_1$, ce à l'aide d'un diviseur par deux 16. Ce diviseur peut être constitué par un simple compteur binaire. De manière préférentielle, le signal à fréquence 2 $F_{sc}$ (et également le signal à fréquence 4 $F_{sc}$) est un signal dont le rapport cyclique égal à 1. Il est transmis directement à une entrée d'autorisation des multiplicateurs 130 et 140 et sous forme inversée à l'aide d'un inverseur 160, c'est-à-dire déphasé de $\pi$ radians, aux multiplicateurs 131 et 141.

Les circuits additionneurs sont également dédoublés : 150 et 151. La sortie de ces additionneurs est transmise via un commutateur électronique K à la sortie générale $S_1$ des circuits de correction 1. Ce commutateur est actionné à la fréquence 2 $F_{sc}$. Il peut être constitué, par exemple, par un multiplexeur logique recevant sur son entrée d'horloge le signal en sortie du diviseur 16.

Les autres fonctions des circuits de correction assurées par les générateurs cos $\phi$ et sin $\phi$ 11 et 12 et le registre 10 ainsi que le fonctionnement général des circuits de correction sont identiques à ce qui a déjà été décrit en relation avec la figure 3 et ne nécessitent pas d'être rappelés.

L'invention n'est pas limitée aux exemples de réalisations concrètes qui ont été décrites à titre d'illustration du dispositif de mise en œuvre du procédé, ni à sa seule application à la correction de signaux de télévision. Elle peut s'appliquer à la resynchronisation de tous signaux numériques issus d'une conversion analogique-numérique et présentant une erreur de phase par rapport à une valeur de référence prédéterminée.

**Revendications**

1. Procédé numérique de correction de l'erreur de phase ($\phi$) par rapport à une valeur de consigne prédéterminée ($\beta$) lors de la conversion analogique-numérique d'un signal sinusoïdal ($V_A$) de fréquence déterminée F en une séquence de premiers signaux numériques ($V_N$) représentatifs, ladite conversion étant réalisée par l'échantillonnage du signal analogique par un signal d'horloge périodique ($V_{4nF}$) de fréquence égale à 4 nF, n étant un nombre entier plus grand où égal à 1 ; procédé caractérisé en ce qu'il comprend les étapes suivantes :

mesure de l'angle de déphasage ($\alpha$) entre le signal analogique et le signal d'horloge et calcul de l'erreur de phase ($\phi$) pour chaque période du signal analogique ;

création, par décalage dans le temps desdits premiers signaux numériques, d'une seconde séquence de signaux numériques, ce décalage étant égal à n périodes du signal d'horloge périodique ;

génération d'un signal numérique représentant la valeur des fonctions cosinus et sinus de l'erreur de phase ;

multiplication des premiers et seconds signaux numériques par les signaux numériques représentant respectivement les valeurs des fonctions cosinus et sinus de ladite erreur de phase ($\phi$) ;

et addition des résultats de ces multiplications pour générer un troisième signal numérique ($V'_N$), ce troisième signal étant égal au premier corrigé de ladite erreur de phase ($\phi$).

2. Procédé selon la revendication 1 caractérisé en ce que le nombre n est choisi égal à 1.

3. Procédé selon l'une quelconque des revendications 1 ou 2 caractérisé en ce que les signaux numériques sont des mots codés binaires à plusieurs bits transmis en parallèle.

4. Dispositif de mise en œuvre du procédé selon la revendication 3 caractérisé en ce qu'il comprend des registres ($R_1$ à $R_n$) à entrées et sorties parallèles, en nombre égal audit nombre entier n et disposés en cascade, chaque registre étant constitué d'un nombre d'éléments bistables égal au nombre de bits desdits mots binaires issus de la conversion analogique-numérique, ces mots étant transmis aux entrées du premier registre ($R_1$) de ladite cascade de registres (10) ; lesdits registres recevant sur une entrée d'horloge le signal d'horloge ($V_{4nF}$) pour commander le décalage des mots binaires d'entrée ($V_N$) au rythme de la fréquence de ce signal (4 nF) des premiers (11) et seconds moyens (12) de génération de fonctions trigonométriques sur leurs entrées un mot binaire ($\phi$) représentant la valeur de ladite erreur de phase et générant, à leurs sorties, respectivement, des mots binaires (cos $\phi$, sin $\phi$) représentant les valeurs correspondantes des fonctions cosinus et sinus, des premiers moyens multiplicateurs binaires (13) à entrées et sorties parallèles reliés par une première série d'entrées aux entrées parallèles du premier registre ($R_1$) de ladite cascade de registres (10) et par une seconde série d'entrées aux sorties des premiers moyens (11) de génération de fonction trigonométrique (cos $\phi$) ; des seconds moyens multiplicateurs binaires (14) à entrées et sorties parallèles reliés par une première série d'entrées aux sorties parallèle du dernier registre ($R_n$) de ladite cascade de registres (10) et par une seconde série d'entrées aux sorties desdits seconds moyens (12) de génération de fonction trigonométrique (sin $\phi$) ; et des moyens additionneurs binaires (15) à entrées et sorties parallèles reliés par des première et seconde

9

séries d'entrées respectivement aux sorties des premiers (13) et seconds (14) moyens multiplicateurs binaires et générant sur ses sorties ($S_1$) un mot binaire résultat de ladite addition.

5. Dispositif selon la revendication 4 caractérisé en ce que les éléments bistables desdits registres ($R_1$ à $R_n$) sont des bascules de type D actionnées au rythme de la fréquence (4 nF) dudit signal d'horloge ($V_{4nF}$).

6. Dispositif selon la revendication 4 caractérisé en ce que les premiers (11) et seconds (12) moyens de génération de fonctions trigonométriques comprennent chacun une mémoire non volatile programmable à lecture seule recevant sur une entrée multiple d'adressage le mot binaire représentant l'erreur de phase ($\phi$) et en ce que à chaque position de mémoire adressable est enregistrée un mot binaire représentant les valeurs des fonctions respectives cosinus et sinus de l'erreur de phase correspondante ($\phi$).

7. Dispositif selon l'une quelconque des revendications 4 à 6 caractérisé en ce que les premiers et seconds moyens multiplicateurs binaires sont constitués chacun de deux circuits multiplicateurs distincts (140-141-130-131) dont les entrées respectives sont connectées en parallèles et fonctionnant en alternance à la fréquence moitié de la fréquence dudit signal d'horloge ; les moyens additionneurs sont également constitués de deux circuits additionneurs distincts (150, 151), les deux séries d'entrées du premier de ces deux circuits additionneurs étant connectées aux premiers des deux circuits additionneurs respectivement des premiers et seconds moyens multiplicateurs binaires et les deux séries d'entrées du second aux seconds circuits des deux circuits additionneurs respectivement des premiers et seconds moyens multiplicateurs binaires, et en ce que les sorties des deux additionneurs sont connectées à des moyens de multiplexage ($K$) actionnés à ladite fréquence moitié.

8. Procédé numérique de correction de l'erreur de phase ($\phi_B$) par rapport à une valeur de consigne prédéterminée, erreur introduite lors de la conversion analogique-numérique d'un signal représentant la composante de chrominance d'un signal de télévision composite du type mis en œuvre dans un système simultané de télévision en couleur, ce signal composite comprenant un signal représentant ladite composante de chrominance modulant en amplitude un signal sinusoïdal haute fréquence dit se sous-porteuse auquel est additionné un signal représentant des informations de luminance et ladite conversion étant réalisée à l'aide d'un signal d'horloge de fréquence quadruple (4 $F_{sc}$) de celle ($F_{sc}$) de cette sous-porteuse, le signal de télévision étant en outre divisé en intervalles de temps (T) représentant des lignes de balayage d'un organe de visualisation et comportant en début de ces intervalles une salve (B) de signaux sinusoïdaux de fréquence égale à celle ($F_{sc}$) de ladite sous-porteuse ; procédé caractérisé en ce qu'il comprend une première phase pendant laquelle la composante de chrominance est extraite du signal composite et une seconde phase pendant laquelle cette composante est corrigée selon le procédé de l'une quelconque des revendications 1 à 3, l'étape de mesure de l'angle de déphasage entre le signal analogique et le signal d'horloge en vue du calcul de l'erreur de phase ($\phi_B$) ayant lieu à chacun desdits intervalles de temps (T) pendant la durée de la salve (B) de signaux sinusoïdaux et par référence à ces signaux.

9. Procédé selon la revendication 8 caractérisé en ce que en outre l'erreur de phase ($\phi_B$) est calculée de façon répétitive pendant toute la durée d'un intervalle de temps (T) d'une ligne de balayage par interpolation, cette interpolation étant effectuée en mémorisant la mesure de l'angle de déphasage ($\alpha_2^{q-1}$) réalisée pendant la salve en début de l'intervalle d'une ligne de balayage d'un rang déterminé (q − 1) jusqu'à la mesure de l'angle de déphasage ($\alpha_1^q$) réalisée pendant l'intervalle de la ligne de balayage de rang (q), à effectuer la différence algébrique ($\alpha_2^{q-1} - \alpha_1^q$) entre ces deux mesures, à diviser en cette différence par un incrément fixe de manière à diviser l'intervalle de temps (T) d'une ligne de balayage en autant de sous-intervalles de durée égale, l'erreur de phase ($\phi_B$) étant incrémentée ou décrémentée dudit incrément selon le signe de la différence algébrique au début de chacun de ces sous-intervalles et en ce que la composante de chrominance extraite est pendant l'intervalle de temps (T) d'une ligne de balayage de rang (q − 1) est également mémorisée pendant la durée de cet intervalle et restituée pendant l'intervalle de temps de la ligne de balayage de rang (q), la correction de phase prenant place pendant cet intervalle de temps.

10. Procédé selon l'une quelconque des revendications 8 ou 9 caractérisé en ce que le système de télévision est le système P.A.L.

11. Procédé selon l'une quelconque des revendications 8 ou 9 caractérisé en ce que le système de télévision est le système N.T.S.C.

12. Dispositif pour la mise en œuvre du procédé de l'une quelconque des revendications 8 à 11 caractérisé en ce qu'il comprend un filtre numérique (4) extrayant le signal représentant la composante de chrominance dudit signal de télévision composite et un dispositif de correction (1) selon l'une quelconque des revendications 4 à 7 connecté à la sortie dudit filtre numérique.

13. Dispositif selon la revendication 12 caractérisé en ce qu'il comprend en outre des premiers moyens retardateurs (53) mémorisant le signal de télévision composite pendant la durée d'un intervalle de temps (T) balayage de ligne et connectés en amont dudit filtre numérique (4) de second moyen retardateurs (56) mémorisant ladite mesure de l'erreur de phase ($\alpha_2^{q-1}$) pendant cette même durée et des circuits de calcul de phase (6) recevant sur deux séries d'entrées ($e_4$, $e_5$) les erreurs de phase instantanées ($\alpha_1^q$) en début de l'intervalle d'une ligne de balayage et retardées ($\alpha_2^{q-1}$) de cette même durée de manière à effectuer ladite interpolation, ces circuits étant connectés en amont du dispositif de correction d'erreur (1).

14. Dispositif selon la revendication 13 caractérisé en ce que les seconds moyens retardateurs (53) comprennent des registres à décalages à entrées et sorties parallèles.

15. Dispositif selon la revendication 13 caractérisé en ce que les circuits de calcul de phase (16) comprennent des premier et second registres à entrées et sorties parallèles (60, 61) enregistrant les valeurs instantannée et retardée de ladite erreur de phase dont lesdites sorties parallèles sont connectées aux entrées d'un comparateur binaire (62) de ces deux valeurs, des premiers moyens (63) recevant du comparateur binaire un premier signal de commande indiquant que la valeur instantannée de l'erreur de phase est plus petite ou égale à celle de la valeur retardée et générant les valeurs binaires vraies ou leurs compléments à deux de la valeur instantannée de l'erreur de phase selon l'état logique du premier signal de commande, des seconds moyens (64) recevant du comparateur binaire un second signal de commande indiquant que la valeur instantannée de l'erreur de phase est plus grande que la valeur retardée et générant les valeurs binaires vraies ou leurs compléments à deux de la valeur retardée de l'erreur de phase selon l'état logique du second signal de commande, un additionneur binaire (65) recevant les signaux de sorties desdits premiers et seconds moyens générateurs (63, 64) et formant la valeur absolue de la différence des valeurs instantannée et retardée de l'erreur de phase, un diviseur programmable (67) générant à partir d'un mot binaire de chargement une séquence d'impulsions à répartition uniformisée pendant l'intervalle de temps (T) d'une ligne de balayage, des moyens de chargement (66) de ce diviseur programmable (67), générant à partir de ladite valeur absolue le mot de chargement et un compteur binaire (68) initialisé à la valeur retardée de l'erreur de phase et recevant sur une entrée d'incrémentation ($e_c$) ou de décrémentation ($e_d$) la séquence d'impulsions selon les états respectifs desdits premier et second signaux de commande, l'évolution de l'état du compteur représentant à tous instants de l'intervalle de temps d'une ligne de balayage la valeur calculée par interpolation de l'erreur de phase ($\phi_B$).

16. Dispositif selon la revendication 15 caractérisé en ce que les premiers (63) et seconds (64) moyens générateurs ainsi que les moyens de chargement (66) du diviseur programmable sont constitués par des mémoires non volatiles programmables à la lecture seule.

**Claims**

1. Digital method for correcting the phase error ($\phi$) with respect to a rated value ($\beta$) during the analog-digital conversion of a sinusoidal signal ($V_A$) of a determined frequency F into a sequence of first representative digital signals ($V_N$), said conversion being performed by sampling the analog signal by means of a periodic clock signal ($V_{4nF}$) of the frequency 4 nF, n being an integer exceeding or equal to 1 ; said method being characterized in that it comprises the following steps :

measurement of the phase shift angle ($\alpha$) between the analog signal and the clock signal and computation of the phase error ($\phi$) for each period of the analog signal ;

generation of a second sequence of digital signals by shifting said first digital signals in time, this shift being equal to n periods of the periodic clock signal ;

generation of a digital signal representing the value of the cosine and sine functions of the phase error ;

multiplication of the first and second digital signals by the digital signals representing the cosine and sine functions, respectively, of said phase error ($\phi$) ;

and adding the results of these multiplications to generate a third digital signal ($V_N$), this third signal being equal to the first signal corrected by said phase error ($\phi$).

2. Method according to claim 1, characterized in that the integer n is selected to be equal to 1.

3. Method according to any of claims 1 and 2, characterized in that the digital signals are coded binary words of a plurality of bits transmitted in parallel.

4. Device for performing the method of claim 3, characterized in that it comprises registers ($R_1$-$R_n$) with parallel inputs and outputs and of a number equal to said integer n and connected in cascade, each register being formed of a number of bistable elements equal to the number of bits of said binary words resulting from the analog-digital conversion, said words being transmitted to the inputs of the first register ($R_1$) of said cascade of registers (10) ; said registers receiving on a clock input the clock signal ($V_{4nF}$) for controlling the shifting of the binary input words ($V_N$) at the rhythm of the frequency of this signal (4 nF), first (11) and second (12) means for generating trigonometric functions having a binary word ($\phi$) at their inputs representing the value of said phase error and generating binary words (cos $\phi$, sin $\phi$) on their outputs respectively representing the values corresponding to the cosine and sine functions, first binary multiplier means (13) having parallel inputs and outputs and connected through a first series of inputs to the parallel inputs of the first register ($R_1$) of said cascade of registers (10) and through a second series of inputs to the outputs of the first trigonometric function (cos $\phi$) generating means (11) ; second binary multiplication means (14) having parallel inputs and outputs connected through a first series of inputs to the parallel outputs of the last register ($R_n$) of said cascade of registers (10) and through a second series of inputs to the outputs of said second trigonometric function (sin $\phi$) generating means (12) ; and binary adder means (15) having parallel inputs and outputs and connected through first and second series of inputs to the outputs of the first (13) and second (14) binary multiplication means, respectively, and generating a binary word resulting from said addition on its outputs (S₁).

5. Device according to claim 4, characterized in that the bistable elements of said registers ($R_1$-$R_n$) are D-type flip-flops operated at the rhythm of the frequency (4 nF) of said clock signal ($V_{4nF}$).

6. Device according to claim 4, characterized in that the first (11) and second (12) trigonometric function generating means each comprise a non-volatile programmable read only memory receiving on a multiple address input the binary word representing the phase error ($\phi$), and in that a binary word representing the values of the respective cosine and sine functions of the corresponding phase error ($\phi$) is stored at each addressable memory position.

7. Device according to any of claims 4 to 6, characterized in that the first and second binary multiplication means are each formed of two distinct multiplier circuits (140-141-130-131) the respective inputs of which are connected in parallel and operating alternately at half of the frequency of said clock signal ; the adding means being also formed of two distinct adding circuits (150, 151), the two series of inputs of the first of these two adding circuits being connected to the first of the two adding circuits respectively of the first and second binary multiplication means and the two series of inputs of the second to the second circuit of the two adding circuits respectively of the first and second binary multiplication means, and in that the outputs of the two adders are connected to multiplexer means (K) operated at said half frequency.

8. Digital method for correcting the phase error ($\phi_B$) with respect to a predetermined rated value, said error being introduced during the analog-digital conversion of a signal representing the chrominance component of a composite television signal of the type used in a simultaneous colour television system, this composite signal comprising a signal representing said chrominance component amplitude modulating a sinusoidal high frequency signal designated as a sub-carrier to which a signal representing luminance information is added, and said conversion being performed by means of a clock signal of quadruple frequency ($4\,F_{sc}$) of that ($F_{sc}$) of said sub-carrier, the television signal being further devided into time intervals (T) representing the scan lines of a visualization member and comprising at the beginning of these intervals a burst (B) of sinusoidal signals of a frequency equal to that ($F_{sc}$) of said sub-carrier ; the method being characterized in that it comprises a first phase during which the chrominance component is extracted from said composite signal and a second phase during which said component is corrected in accordance with the method of any of claims 1 to 3, the step of measurement of the phase shift angle between the analog signal and the clock signal for computing the phase error ($\phi_B$) being performed at each of said time intervals (T) during the duration of the burst (B) of sinusoidal signals and by reference thereto.

9. Method according to claim 8, characterized in that the phase error ($\phi_B$) is computed in repetitive manner during the entire duration of a time interval (T) of a scan line and by interpolation, said interpolation being performed by storing the measurement of the phase shift angle ($\alpha_2^{q-1}$) performed during the burst at the beginning of the interval of a scan line of a determined order (q − 1) until the measurement of the phase shift angle ($\alpha_1^q$) performed during the interval of the scan line of the order (q), providing the algebraic difference ($\alpha_2^{q-1} - \alpha_1^q$) between these two measurements, dividing this difference by a fixed increment in a manner to divide the time interval (T) of a scan line into as many sub-intervals of equal duration, the phase error ($\phi_B$) being incremented or decremented by said increment in accordance with the sign of the algebraic difference at he beginning of each of these sub-intervals, and in that the chrominance component extracted during the time interval (T) of a scan line of the order (q − 1) is also stored during the duration of this interval and restituted during the time interval of the scan line of the order (q), the phase correction occuring during this time interval.

10. Method according to any of claims 8 and 9, characterized in that the television system in the P.A.L. system.

11. Method according to any of claims 8 and 9, characterized in that the television system is the N.T.S.C. system.

12. Device for performing the method of any of claims 8 to 11, characterized in that it comprises a digital filter (4) extracting the signal representing the chrominance component of said composite television signal and a correction device (1) according to any of claims 4 to 7 connected at the output of said digital filter.

13. Device according to claim 12, characterized in that it further comprises first delay means (53) storing the composite television signal during the duration of a time interval (T) of the line scan and connected upstream of said digital filter (4), second delay means (56) storing said measurement of the phase error ($\alpha_2^{q-1}$) during the same duration, and phase computation circuits (6) receiving on two series of inputs ($e_4$, $e_5$) the momentary phase errors ($\alpha_1^q$) at the beginning of the interval of a scan line and phase errors delayed ($\alpha_2^{q-1}$) by the same duration, in a manner to perform said interpolation, these circuits being connected upstream of said error correction device (1).

14. Device according to claim 13, characterized in that the second delay means (53) comprise shift registers having parallel inputs and outputs.

15. Device according to claim 13, characterized in that the phase computation circuits (16) comprise first and second registers having parallel inputs and outputs (60, 61) storing the momentary and delayed values of said phase error and the parallel outputs of which are connected to the inputs of a binary comparator (62) for comparing these two values, first means (63) receiving from the binary comparator a first control signal indicating that the momentary value of the phase error is smaller than or equal to the delayed value, and generating the true binary values or their two's complement of the momentary value of the phase error in accordance with the logic state of said first control signal, second means (64) receiving from the binary comparator a second control signal indicating that the momentary value of the phase error exceeds the delayed value, and generating true binary values or their two's complement of the delayed value of the phase error in accordance with the logic state of said second control signal, a binary adder (65) receiving the output signals of said first and second generator means (63, 64) and forming the absolute value of the difference of the momentary and delayed values of the phase error, a programmable divider (67) generating from a binary loading word a sequence of pulses of uniform distribution during the time interval (T) of a scan line, loading means (66) for loading this programmable divider (67) and generating the loading word from said absolute value, and a binary counter (68) initialized to the delayed value of the phase error and receiving the sequence of pulses on an incrementation input ($e_c$) or decrementation input ($e_d$) in accordance with the respective states of said first and second control signals, the evolution of the state of the counter representing at any time of the time interval of a scan line the value of the phase error ($\phi_B$) computed by interpolation.

16. Device according to claim 15, characterized in that the first (63) and second (64) generator means as well as the loading means (66) of the programmable divider are formed of non-volatile programmable read only memories.

### Ansprüche

1. Digitales Verfahren zur Korrektur des Phasenfehlers ($\phi$) gegenüber einem vorbestimmten Sollwert ($\beta$) bei der Analog/Digital-Umsetzung eines sinusförmigen Signals ($V_A$) bestimmter Frequenz F in eine Folge von ersten repräsentativen Digitalsignalen ($V_N$), wobei die Umsetzung durch Abtastung des Analogsignals mit einem periodischen Taktsignal ($V_{4nF}$) der Frequenz 4 nF durchgeführt wird, worin n eine ganze Zahl ist, die größer als oder gleich 1 ist ; wobei das Verfahren dadurch gekennzeichnet ist, daß es folgende Schritte enthält :

Messung des Phasenverschiebungswinkels ($\alpha$) zwischen dem Analogsignal und dem Taktsignal und Berechnung des Phasenfehlers ($\phi$) für jede Periode des Analogsignals ;

durch zeitliche Verschiebung der genannten ersten Digitalsignale erfolgende Erzeugung einer zweiten Folge von Digitalsignalen, wobei diese Verschiebung gleich n Perioden des periodischen Taktsignals beträgt ;

Erzeugung eines Digitalsignals, welches den Wert der Kosinus- und Sinusfunktionen des Phasenfehlers darstellt,

Multiplizieren der ersten und zweiten Digitalsignale mit den Digitalsignalen, welche die Werte für die Kosinusfunktion bzw. Sinusfunktion des genannten Phasenfehlers ($\phi$) darstellen ;

und Addition der Resultate dieser Multiplikationen zur Erzeugung eines dritten Digitalsignals ($V_N$), wobei dieses dritte gleich dem ersten, um den genannten Phasenfehler ($\phi$) korrigierten Signal ist.

2. Verfahren nach Anspruch 1, dadurch gekennzeichnet, daß die ganze Zahl n gleich 1 gewählt ist.

3. Verfahren nach Anspruch 1 oder 2, dadurch gekennzeichnet, daß die Digitalsignale kodierte Binärwörter aus mehreren parallel übertragenen Bits sind.

4. Vorrichtung zur Durchführung des Verfahrens nach Anspruch 3, dadurch gekennzeichnet, daß es Register ($R_1$ bis $R_n$) mit parallelen Eingängen und Ausgängen umfaßt, deren Anzahl gleich der ganzen Zahl n ist und die in Kaskade geschaltet sind, wobei jedes Register gebildet aus einer Anzahl von bistabilen Elementen, die gleich der Zahl von Bits der Binärwörter ist, welche durch die Analog/Digital-Umsetzung entstehen, wobei diese Wörter den Eingängen des ersten Registers ($R_1$) der genannten Kaskade von Registern (10) zugeführt werden ; wobei diese Register an einem Takteingang das Taktsignal ($V_{4nF}$) empfangen, um die Verschiebung der binären Eingangswörter ($V_N$) im Rhythmus der Frequenz dieses Signals (4 nF) zu steuern, erste (11) und zweite Mittel (12) zur Erzeugung von trigonometrischen Funktionen enthält, an deren Eingängen ein Binärwort ($\phi$) den Wert des genannten Phasenfehlers darstellt und die an ihren Ausgängen Binärwörter (cos $\phi$, sin $\phi$) erzeugen, von denen das erste den der Kosinusfunktion entsprechenden Wert und das zweite den der Sinusfunktion entsprechenden Wert darstellt, erste binäre Multipliziermittel (13) mit parallelen Eingängen und Ausgängen umfaßt, welche über eine erste Reihe von Eingängen mit den parallelen Eingängen des ersten Registers ($R_1$) der genannten Kaskade von Registern (10) und über eine zweite Reihe von Eingängen mit den Ausgängen der ersten Mittel (11) zur Erzeugung von trigonometrischen Funktionen (cos $\phi$) verbunden sind ; zweite binäre Multipliziermittel (14) mit parallelen Eingängen und Ausgängen umfaßt, die über eine erste Reihe von Eingängen mit den parallelen Ausgängen des letzten Registers ($R_n$) der genannten Kaskade von Registern (10) und über eine zweite Reihe von Eingängen mit den Ausgängen der genannten zweiten Mittel (12) zur Erzeugung von trigonometrischen Funktionen (sin $\phi$) verbunden sind ; und binäre Addiermittel (15) mit parallelen Eingängen und Ausgängen umfaßt, die über eine erste bzw. eine zweite Reihe von Eingängen mit den Ausgängen der ersten (13) bzw. zweiten (14) binären Multipliziermittel verbunden sind und an ihren Ausgängen ($S_1$) ein Binärwort erzeugen, welches das Ergebnis der genannten Addition ist.

5. Vorrichtung nach Anspruch 4, dadurch gekennzeichnet, daß die bistabilen Elemente der genannten Register ($R_1$ bis $R_n$) Kippschaltungen vom D-Typ sind, welche im Rhythmus der Frequenz (4 nF) des genannten Taktsignals ($V_{4nF}$) betätigt werden.

6. Vorrichtung nach Anspruch 4, dadurch gekennzeichnet, daß die ersten (11) und die zweiten (12) Mittel zur Erzeugung von trigonometrischen Funktionen jeweils einen programmierbaren nichtflüchtigen Lesespeicher enthalten, der an einem Mehrfach-Adressiereingang das Binärwort empfängt, welches den Phasenfehler ($\phi$) darstellt, und daß an jedem adressierbaren Speicherplatz ein Binärwort gespeichert ist, welches die Werte der Kosinusfunktion bzw. Sinusfunktion des entsprechenden Phasenfehlers ($\phi$) darstellt.

7. Vorrichtung nach einem der Ansprüche 4 bis 6, dadurch gekennzeichnet, daß die ersten und die zweiten binären Multipliziermittel jeweils durch zwei getrennte Multiplizierschaltungen (140-141-130-131) gebildet sind, deren jeweilige Eingänge parallel geschaltet sind und alternierend mit der halben Frequenz des Taktsignals arbeiten ; wobei die Addiermittel ebenfalls aus zwei getrennten Addierschaltungen (150, 151) gebildet sind und die zwei Reihen von Eingängen der ersten dieser zwei Addierschaltungen mit den ersten der zwei Addierschaltungen der ersten bzw. zweiten binären Multipliziermittel verbunden sind und die zwei Reihen von Eingängen der zweiten mit den zweiten Schaltungen der zwei Addierschaltungen der ersten bzw. zweiten binären Multipliziermittel verbunden sind, und daß die Ausgänge der zwei Addierer mit Multiplexiermitteln (K) verbunden sind, welche mit der genannten halben Frequenz angesteuert werden.

8. Digitales Verfahren zur Korrektur des Phasenfehlers ($\phi_B$) gegenüber einem vorbestimmten Sollwert, wobei der Fehler bei der Analog/Digital-Umsetzung eines Signals entsteht, das die Chrominanzkomponente eines zusammengesetzten Fernsehsignals von solcher Art darstellt, wie es bei einem Farbfernseh-Simultansystem verwendet wird, wobei dieses zusammengesetzte Signal ein Signal enthält, welches die genannte Chrominanzkomponente darstellt und ein sinusförmiges, als Hilfsträger bezeichnetes Hochfrequenzsignal amplitudenmoduliert, welchem ein Signal hinzugefügt wird, das die Luminanzinformation darstellt, und wobei die genannte Umsetzung mittels eines Taktsignals der vierfachen Frequenz (4 $F_{sc}$) der Frequenz ($F_{sc}$) dieses Hilfsträgers erfolgt, wobei ferner das Fernsehsignal in Zeitintervalle (T) eingeteilt wird, welche die Ablenkzeilen eines Anzeigeorgans darstellen und am Beginn dieser Intervalle eine Folge (B) von sinusförmigen Signalen mit der Frequenz ($F_{sc}$) des Hilfsträgers enthält ; wobei das Verfahren dadurch gekennzeichnet, ist daß es eine erste Phase umfaßt, während welcher die Chrominanzkomponente aus dem zusammengesetzten Signal extrahiert wird, und eine zweite Phase enthält, während welcher diese Komponente durch das Verfahren nach einem der Ansprüche 1 bis 3 korrigiert wird, wobei der Schritt des Messens des Phasenverschiebungswinkels zwischen dem Analogsignal und dem Taktsignal zur Berechnung des Phasenfehlers ($\phi_B$) in jedem der genannten Zeitintervalle (T) während der Dauer der Folge (B) von Sinussignalen sowie in Bezug auf diese Signale erfolgt.

9. Verfahren nach Anspruch 8, dadurch gekennzeichnet, daß ferner der Phasenfehler ($\phi B$) wiederholt während der gesamten Dauer eines Zeitintervalls (T) einer Ablenkzeile durch Interpolation berechnet wird, wobei diese Interpolation durchgeführt wird, indem der Meßwert des Phasenverschiebungswinkels ($\alpha_2^{q-1}$), der während der Signalfolge zu Beginn des Intervalls einer Ablenkzeile einer vorbestimmten Ordnungszahl (q − 1) gewonnen wurde, bis zur Messung des Phasenverschiebungswinkels ($\alpha_1^q$), die während des Intervalls der Ablenkzeile der Ordnungszahl (q) durchgeführt wird, gespeichert wird, die algebraische Differenz ($\alpha_2^{q-1} - \alpha_1^q$) zwischen diesen beiden Meßwerten gebildet wird, diese Differenz durch ein festes Inkrement dividiert wird, so daß das Zeitintervall (T) einer Ablenkzeile in ebenso viele Unterintervalle gleicher Dauer unterteilt wird, wobei der Phasenfehler ($\phi_B$) je nach den Vorzeichen der algebraischen Differenz am Beginn jedes dieser Unterintervalle inkrementiert oder dekrementiert wird, und daß die während des Zeitintervalls (T) einer Ablenkzeile der Ordnungszahl (q − 1) extrahierte Chrominanzkomponente ebenfalls während der Dauer dieses Intervalls gespeichert wird und während des Zeitintervalls der Ablenkzeile der Ordnungszahl (q) wieder ausgegeben wird, wobei die Phasenkorrektur während dieses Zeitintervalls erfolgt.

10. Verfahren nach einem der Ansprüche 8 und 9, dadurch gekennzeichnet, daß das Fernesehsystem das P.A.L.-System ist.

11. Verfahren nach Anspruch 8 oder 9, dadurch gekennzeichnet, daß das Fernsehsystem das N.T.S.C.-System ist.

12. Vorrichtung zur Durchführung des Verfahrens nach einem der Ansprüche 8 bis 11, dadurch gekennzeichnet, daß sie ein digitales Filter (4) enthält, welches das Signal extrahiert, das die Chrominanzkomponente des genannten zusammengesetzten Fernsehsignals darstellt, und eine Korrekturvorrichtung (1) nach einem der Ansprüche 4 bis 7, umfaßt, welche an den Ausgang des Digitalfilters angeschlossen ist.

13. Vorrichtung nach Anspruch 12, dadurch gekennzeichnet, daß sie ferner versehen ist mit ersten Verzögerungsmitteln (53), welche das zusammengesetzte Fernsehsignal während der Dauer eines Zeitintervalls (T) der Zeilenablenkung speichern und dem digitalen Filter (4) vorgeschaltet sind, zweiten Verzögerungsmitteln (56), welche den genannten Meßwert des Phasenfehlers ($\alpha_2^{q-1}$) während dieser selben Dauer speichern, und mit Phasenberechnungsschaltungen (6), welche an zwei Reihen von Eingängen ($e_4$, $e_5$) die Momentanwerte ($\alpha_1^q$) der Phasenfehler am Anfang des Intervalls einer Ablenkzeile und die um diese selbe Dauer verzögerten Werte derselben ($\alpha_2^{q-1}$) empfangen, so daß die genannte Interpolation durchgeführt wird, wobei diese Schaltungen der Fehlerkorrekturvorrichtung (1) vorgeschaltet sind.

14. Vorrichtung nach Anspruch 13, dadurch gekennzeichnet, daß die zweiten Verzögerungsmittel (53) Schieberegister mit parallelen Eingängen und Ausgängen umfassen.

15. Vorrichtung nach Anspruch 13, dadurch gekennzeichnet, daß die Phasenberechnungsschaltungen (16) versehen sind mit ersten und zweiten Registern mit parallelen Eingängen und Ausgängen (60, 61), welche die Momentanwerte bzw. verzögerten Werte des genannten Phasenfehlers speichern und deren parallele Ausgänge mit den Eingängen eines binären Komparators (62) zum Vergleichen dieser zwei Werte verbunden sind, ersten Mitteln (63), welche von dem binären Komparator ein erstes Steuersignal empfangen, welches anzeigt, daß der Momentanwert des Phasenfehlers kleiner als der oder gleich dem verzögerten Wert ist, und je nach dem Logikzustand des ersten Steuersignals wahre Binärwerte oder ihr Zweierkomplement für den Momentanwert des Phasenfehlers erzeugen, zweiten Mitteln (64), welche von dem binären Komparator ein zweites Steuersignal empfangen, welches anzeigt, daß der Momentanwert des Phasenfehlers größer ist als der verzögerte Wert, und je nach dem Logikzustand des zweiten Steuersignals die wahren Binärwerte oder deren Zweierkomplement für den verzögerten Wert des Phasenfehlers erzeugen, einem binären Addierer (65), welcher die Ausgangssignale der ersten und zweiten Generatormittel (63, 64) empfangen und den Absolutwert der Differenz der Momentanwerte unde verzögerten Werte des Phasenfehlers bilden, einem programmierbaren Teiler (67), der aus einem binären Ladewort eine Folge von Impulsen mit vergleichmäßigter Verteilung während des Zeitintervalls (T) einer Ablenkzeile erzeugt, Mitteln (66) zum Laden dieses programmierbaren Teilers (67), welche aus dem genannten Absolutwert das Ladewort erzeugen, und mit einem Binärzähler (68), der auf den verzögerten Wert des Phasenfehlers initiiert wird und je nach den jeweiligen Zuständen der ersten und zweiten Steuersignale die Impulsfolge an einem Inkrementiereingang ($e_c$) óder an einem Dekrementiereingang ($e_d$) empfängt, wobei die Entwicklung des Zählerstandes zu allen Zeitpunkten des Zeitintervalls einer Ablenkzeile den durch Interpolation des Phasenfehlers ($\phi_B$) berechneten Wert darstellt.

16. Vorrichtung nach Anspruch 15, dadurch gekennzeichnet, daß die ersten (63) und zweiten (64) Generatormittel sowie die Mittel (66) zum Laden des programmierbaren Teilers durch nichtflüchtige programmierbare Lesespeicher gebildet sind.

15

# FIG.1

# FIG.2

0 071 506

FIG.3

FIG.4

**F I G. 5**

CIRCUITS DE CORRECTION (LUMINANCE) — 57

FILTRE — 4

RETARDATEUR — 53

CONVERTISSEUR ANALOGIQUE - NUMERIQUE — 2

OSCILLATEUR ASSERVI — 50

CIRCUIT DE MESURE DE PHASE — 54

CIRCUITS DE CALCUL DE PHASE — 6

CIRCUIT DE COMMANDE — 55

DIVISEUR — 52

REGISTRE TAMPON — 56

GENERATEUR DE SIGNAUX DEPHASES — 51

CIRCUITS DE CORRECTION (CHROMINANCE) — 1

ADDITIONNEUR — 58

CIRCUITS DE CORRECTION PRINCIPAL — 7

$E_1$, $e_1$, $e_2$, $e_3$, $e_4$, $e_5$, $e_6$, $e_7$, $e_8$, $e_9$, $e_{10}$, $e_{11}$, $e_{12}$

$S_1$, $S_2$, $S_3$

$F\ell$, $F\ell\ell$, $H\ell$

# FIG.6

FIG.7

0 071 506

**0 071 506**

# FIG.8